# EUROPÄISCHE PATENTSCHRIFT

(11) **EP 3 528 353 B1**
(45) Veröffentlichungstag und Bekanntmachung des Hinweises auf die Patenterteilung: **08.11.2023**
(21) Anmeldenummer: 18173819.6
(22) Anmeldetag: 23.05.2018
(51) Int. Cl.: H02G 5/04, H02B 1/48, H05K 1/14, H01R 25/14, H02G 5/08, H02G 3/10, H02B 1/42, H05K 1/02

(54) **ABGREIFVORRICHTUNG ZUR ÜBERTRAGUNG ELEKTRISCHER ENGERGIE**
CONNECTION DEVICE FOR THE TRANSMISSION OF ELECTRIC POWER
DISPOSITIF DE PRÉLÈVEMENT PERMETTANT DE TRANSMETTRE DE L'ÉNERGIE ÉLECTRIQUE

(30) Priorität: 19.02.2018 DE 102018103669
(43) Veröffentlichungstag der Anmeldung: 21.08.2019
(60) Teilanmeldung: 19151491.8
(73) Patentinhaber: TGW Mechanics GmbH, 4600 Wels (AT)
(72) Erfinder: Pfeiffer-Wagner, Klaus, 92637 Weiden (DE)
(74) Vertreter: Peters, Andreas

(56) Entgegenhaltungen:
- EP-A1- 1 209 788
- EP-A2- 0 312 871
- EP-A2- 0 828 323
- WO-A1-92/04813
- WO-A1-2017/135071
- DE-A1- 4 446 601
- DE-A1-102016 000 059
- US-A- 4 908 738

## Beschreibung

Die vorliegende Erfindung betrifft eine Abgreifvorrichtung zur Übertragung elektrischer Energie von einer, vorzugsweise räumlich fixierten, Leitungsschiene auf eine entlang der Leitungsschiene bewegbare oder ebenso räumlich fixierte Abgreifeinrichtung gemäß dem Oberbegriff des Patentanspruches 1.

Bei der Leitungsschiene kann es sich insbesondere um eine Anordnung von einer Mehrzahl von parallel zueinander verlegten länglichen elektrischen Leitern, welche beispielsweise einzeln oder gemeinsam in weiteren Isolationselementen, z.B. Plastikkörpern, gelagert sind, handeln. Zudem kann die Leitungsschiene in einem Fabrikationsraum, beispielsweise auf dessen Fußboden, fest montiert sein, ohne, dass sich während des Betriebs die Leitungsschiene relativ zum Fußboden bewegt.

Beispielsweise können die einzelnen elektrischen Leiter schienenförmig, vorzugsweise auch entlang einer Schiene oder in Form einer Schienenführung, geführt werden.

Um nun zum Beispiel einen Fertigungsroboter beständig, d.h. dauerhaft mit elektrischer Energie zu versorgen, ist es daher oftmals nötig, zwischen der oben genannten Leitungsschiene und einem solchen elektrisch zu betreibenden Fertigungsroboter oder einem sonstigen elektrisch betreibbaren Element, eine Abgreifvorrichtung zu installieren.

Beispielsweise ist die Abgreifvorrichtung entlang der Haupterstreckungsrichtung der Leitungsschiene vorzugsweise zusammen mit einem solchen Roboter bewegbar, während der Bewegung jedoch in ständigem elektrischem Kontakt mit der Leitungsschiene.

Alternativ hierzu können auch beide Komponenten räumlich fixiert sein.

Mit anderen Worten ermöglicht daher die Abgreifvorrichtung eine zuverlässige Stromversorgung des Roboters oder des sonstigen elektrischen Elementes mit elektrischer Energie, unabhängig davon, an welcher Stelle sich der Roboter relativ zu der Leitungsschiene befindet, solange die Abgreifvorrichtung in zuverlässigem elektrischem Kontakt mit der Leitungsschiene steht.

Dabei bedarf es jedoch einer Vorrichtung, welche die Leitungsschiene und die Abgreifvorrichtung elektrisch leitend miteinander kontaktiert. Hierzu dient die erfindungsgemäße Abgreifvorrichtung.

Die EP 0 312 871 A2 zeigt ein mit einem Gehäuse versehenen Adapter für den Anschluss von Gasentladungslampen an Stromschienen mit im Wesentlichen U-förmigem Querschnitt, in deren Inneren spannungsführende Leiter angeordnet sind. Das Gehäuse weist einen ersten Abschnitt auf, der bei korrektem Einsetzen in das Innere der Schiene ragt und der verstellbare Rastelemente zur Fixierung des Adapters auf der Stromschiene und ferner verstellbare elektrisch leitende Kontaktzungen für den elektrischen Anschluss der Gasentladungslampen aufweist. Darüber hinaus ist ein zweiter, außerhalb der Stromschiene liegender Abschnitt mit einem Steuerhebel zur Betätigung dieser Verriegelungselemente und/oder der Kontaktzungen versehen. Die Leuchte mit der Gasentladungslampe ist direkt oder indirekt mit diesem zweiten Teil verbunden. Im Inneren des Gehäuses befindet sich ein elektronisches Vorschaltgerät und/oder ein elektronischer Transformator. Die Vorschalteinheit und die, den Transformator bildenden Schaltelemente, wie Spulen, Kondensatoren, Widerstände, Transistoren und dergleichen, sind auf mindestens einer Leiterplatte im Gehäuse angeordnet.

Die EP 1 209 788 A1 zeigt ein Gerät, das zum Aufstecken auf Stromschienen in elektrischen Versorgungseinheiten geeignet ist und welches ein Isoliergehäuse, mindestens vier gegeneinander isolierte Steckkontakte und eine Anschlussvorrichtung mit mindestens vier Anschlüssen für elektrische Leitungen aufweist. Jeder Steckabschnitt ist über eine Anschlussleitung mit einem der vier Anschlüsse elektrisch verbunden und zumindest ein Teil der Anschlussleitungen weist jeweils ein elektrisches Schutzteil auf. Eigenständige Ansprüche sind auch enthalten für eine Verwendung des Kopplers zum Ein- und Auskoppeln von elektronischen Datensignalen in Powerline-Kommunikationssystemen und eine Verwendung zum Einspeisen/Abgreifen von elektrischer Energie.

Die EP 0 828 323 A2 weist ein Schienensystem auf, welches ein Trägerprofil mit einem kanalförmigen Kammersystem zur Aufnahme einer Anzahl von Stromschienen für den Anschluss einer Anzahl von elektrischen Geräten umfasst. Das Trägerprofil ist vorzugsweise aus einem ersten tragenden und leitenden Profilteil und einem darin angeordneten zweiten isolierenden Profilteil gebildet. Das erste tragende Profilteil besteht vorzugsweise aus Leichtmetall und das zweite isolierende Profilteil besteht aus Kunststoff.

Die DE 44 46 601 A1 zeigt eine Anordnung von elektrischen Einheiten in einer Notbeleuchtungsanlage, welche mindestens eine Trägerplatte mit mehreren voneinander isolierten Stromschienen, die AC-, DC- und informationsführende Leiter enthalten. Bei den Einheiten handelt es sich um Module mit Federkontakten, die auf die Stromschienen aufgeschnappt werden. Die Module werden aneinandergereiht und die Stromschienen stellen alle notwendigen Stromanschlüsse her. Die Trägerplatte ist brückenartig aufgebaut, sodass die Leiter unter ihr hindurchgeführt werden können. Das Sammelschienenfeld hat einen Abdeckdeckel mit Schlitzen über den Schienen, damit die Federkontakte der Module eingesteckt werden können. Die Trägerplatte hat Schraubklemmen für die Stromschienen.

Die WO 92/04813 A1 betrifft ein Prozess-Interface-System, bei dem einkanalige, in Kompakt-IC-Technik ausgeführte Module in reihenklemmenähnlichen Blöcken vom gleichen Typ wie Standard-Reihenklemmen für Tragschienen untergebracht sind. Die einkanaligen Module sind in wenigen verschiedenen Versionen ausgeführt, die bei der Installation für ihren Einsatzbereich als Al- oder AO-Schnittstelleneinheit bzw. als DI- oder DO-Schnittstelleneinheit sowie für ihren Spannungsbereich programmiert werden. Jede Schnittstelleneinheit kommuniziert direkt mit dem Systemcomputer über einen seriellen Bus in Form von elektrisch leitenden Bahnen, die auf der Tragschiene angebracht sind, auf der das jeweilige Schnittstellenmodul montiert wurde. Die Module werden auch über Leiterbahnen auf der Oberfläche der Tragschiene mit Strom versorgt. Der Anschluss von Messwertgebern erfolgt direkt an das jeweilige Schnittstellenmodul. Die Anschlussklemmen sind mit den Schnittstellenmodulen frei mischbar, z.B. für die Spannungsverteilung zu den Messwertaufnehmern.

Die DE 10 2016 000 059 A1 zeigt eine Kontaktvorrichtung zur Übertragung von elektrischer Energie von einer vorzugsweise ortsfesten Sammelschiene auf eine entlang der Sammelschiene beweglichen Abgriffsschiene, umfassend mindestens ein Anschlußgehäuse, wobei die Stromsammelschiene durch das Anschlußgehäuse mechanisch mit der Abgriffsschiene verbunden ist, mindestens einen Kombiclip, wobei der Kombiclip mit einem Teil des Außenumfangs des Anschlußgehäuses mechanisch lösbar in Eingriff gebracht wird und eine mechanische Verbindung zwischen dem Anschlußgehäuse und einem Anschlußbügel herstellt, und mindestens ein Leistungssteckergehäuse, wobei das Leistungssteckergehäuse mechanisch und von außen auf der Stromsammelschiene und/oder auf der Abgriffsschiene so positioniert ist, dass durch das Leistungssteckergehäuse eine mechanische Verbindung zwischen dem Anschlußgehäuse und der Stromsammelschiene und/oder der Anschlußschiene hergestellt wird.

Die US 4,908,738 A zeigt eine Motorantriebseinheit zur Steuerung eines Wechselstrommotors, der die Spindel oder die Vorschubwelle einer Werkzeugmaschine antreibt, und welche für die automatische Montage geeignet ist, bei der eine Vielzahl von elektrischen Bauteilen montiert und verdrahtet wird. Gemäß der erfindungsgemäßen Motorantriebseinheit sind ein oberer Rahmen, der eine Leiterplatte mit einer elektrischen Schaltung trägt, die Steuerhalbleiter verwendet, und ein unterer Rahmen zur Montage einer Wärmeabstrahlungsvorrichtung, die einen Gleichrichter oder dergleichen sowie einen Leistungswiderstand trägt, aus Kunstharz hergestellt. Zwischen den beiden Rahmen ist eine Leistungsplatine eingefügt, auf der die Bauteile der Wärmeabstrahlungsvorrichtung und des Leistungswiderstandes montiert und durch Schrauben verbunden sind. Die beiden Rahmen sind durch Schrauben miteinander verbunden.

In der WO 2017/135071 A1 wird gezeigt, dass eine Leistungsumwandlungsvorrichtung versehen ist mit einem Halbleitermodul, einem ersten elektronischen Schaltungssubstrat, einem zweiten elektronischen Schaltungssubstrat und einem Aufnahmekörper zum Aufnehmen sowohl des ersten elektronischen Schaltungssubstrats als auch des zweiten elektronischen Schaltungssubstrats. Der Aufnahmekörper umfasst einen ersten Befestigungsabschnitt, an dem das erste elektronische Schaltungssubstrat befestigt ist, und einen zweiten Befestigungsabschnitt, an dem das zweite elektronische Schaltungssubstrat befestigt ist. Der Unterbringungskörper ist so konfiguriert, dass sich das zweite elektronische Schaltungssubstrat nicht zwischen dem ersten Befestigungsabschnitt des Unterbringungskörpers und dem ersten elektronischen Schaltungssubstrat in Richtung der Substratdicke befindet und das erste elektronische Schaltungssubstrat nicht zwischen dem zweiten Befestigungsabschnitt des Unterbringungskörpers und dem zweiten elektronischen Schaltungssubstrat in Richtung der Substratdicke befindet.

Die obige Abgreifvorrichtung zur Übertragung elektrischer Energie von einer, vorzugsweise räumlich fixierten, Leitungsschiene auf eine entlang der Leitungsschiene bewegbaren oder ebenso räumlich fixierten Abgreifvorrichtung, umfasst zumindest ein Verbindungsgehäuse, wobei über das Verbindungsgehäuse die Leitungsschiene mechanisch mit der Abgreifvorrichtung verbunden ist oder verbindbar ist, sowie eine Stromabgreifvorrichtung, welche Schleifkontaktelemente zur Abnahme elektrischer Energie von der Leitungsschiene umfasst, wobei die Stromabgreifvorrichtung mechanisch fest mit dem Verbindungsgehäuse verbunden ist.

Das Verbindungsgehäuse umfasst zumindest einen Basisträger, an dem zumindest zwei Steuerungsplatinen montiert sind, wobei der Basisträger zwischen den beiden Steuerungsplatinen montiert ist.

Der Basisträger kann in Form einer Basisplatte ausgebildet sein und aus einem elektrisch isolierenden Material bestehen, auf welchem elektrische Leitungen verlegt sind. Hierzu kommt ein Kunststoff oder Keramik in Frage.

Zudem umfasst die Verbindungsvorrichtung eine Stromabgreifvorrichtung, welche wiederrum zumindest ein Schleifkontaktelement zur Abnahme elektrischer Energie von der Leitungsschiene umfasst. Die Schleifkontaktelemente sind durch den Basisträger hindurch geführt und weisen auf einer der Leitungsschiene abgewandten Seite des Basisträgers, einen Kontaktierungsbereich auf, mittels dessen zumindest eine Leiterplatine der Verbindungsvorrichtung und/oder zumindest eine Leiterplatine der Abgreifvorrichtung elektrisch leitend kontaktierbar ist.

Zum Beispiel sind die Schleifkontaktelemente in Form von Schleifaufsteckelementen ausgebildet, sodass das Verbindungsgehäuse werkzeugfrei auf die Leitungsschiene aufsteckbar ist.

Ein Schleifaufsteckelement kann im Sinne der Erfindung ein Element sein, welches an eine Leitung der Leitungsschiene aus einer Richtung angeordnet werden kann und während des Anpositioniervorgangs eine Steckverbindung zwischen der Leitungsschiene oder sogar an eine der Leitungen selbst und dem Verbindungsgehäuse entsteht. Dabei kann die Steckverbindung in Form einer Plug-and-Place Verbindung ausgebildet sein.

Auch kann die Steckverbindung in Form einer Clipsverbindung ausgebildet sein. Eine solche Clipsverbindung kann ein Schnappelement (den Clips) umfassen, welcher sich nach dem Einrasten umfänglich um eine Leitung der Leitungsschiene legt.

Gemäß zumindest einer Ausführungsform ist die mechanische Verbindung mit dem Verbindungsgehäuse, insbesondere nur, durch seitliches Aufschieben (= Aufklippen) der Schleifkontaktverbindung, insbesondere der Clipsverbindung, auf jede der Leitung hergestellt.

Die Verbindung zwischen dem Verbindungsgehäuse und der Leitungsschiene ist zum Beispiel frei von jeglichen weiteren Befestigungselementen, wie beispielsweise Schrauben, Haftbolzen oder Spannelementen.

Alternativ oder zusätzlich umfasst die hier beschriebene Abgreifvorrichtung einen Combi-Clip, wobei der Combi-Clip mechanisch lösbar mit einem Teil des Außenumfangs des Verbindungsgehäuses in Eingriff gebracht ist, um eine mechanische Verbindung zwischen dem Verbindungsgehäuse und einem Verbindungsträger zu erzeugen. Zum Beispiel trägt und führt der Verbindungsträger die Leitungsschiene mechanisch stabil.

Auf dem Verbindungsgehäuse sind daher, vorzugsweise alle restlichen Bauteile der Abgreifvorrichtung beweglich oder unbeweglich gelagert. Beispielsweise bewegt sich während der Bewegung eines solchen Roboters die gesamte Kontaktierungsvorrichtung inklusive des Verbindungsträgers mit dem Roboter entlang der Haupterstreckungsrichtung der Leitungsschiene mit.

Gemäß zumindest einer Ausführungsform ist der Combi-Clip mechanisch lösbar mit einem Teil des Außenumfangs des Verbindungsgehäuses in Eingriff gebracht und eine mechanische Verbindung zwischen dem Verbindungsgehäuse und einem Verbindungsträger ist somit derart erzeugt, dass sich zwischen einer Wand des Combi-Clips und der Stromabgreifvorrichtung ein in Verfahrrichtung des Verbindungsgehäuses beidseits offener Hohlraum ausbildet, durch den hindurch die Leitungsschiene geführt ist.

Die Verfahrrichtung verläuft vorzugsweise parallel zu einer Haupterstreckungsrichtung der Leitungsschiene.

Vorzugsweise ist der Combi-Clip mit einem elektrisch isolierenden Material, beispielsweise mit einem Kunststoff, gebildet. In diesem Zusammenhang ist es denkbar, dass es sich bei dem Material des Combi-Clips um einen Ein- oder Mehrkomponenten-Kunststoff handelt, welcher beispielsweise mittels eines "injection molding"-Verfahrens hergestellt ist. Alternativ kann der Combi-Clip ganz oder teilweise auch mit einer Keramik gebildet sein. Zwar ist eine Keramik verhältnismäßig teuer in der Anschaffung, jedoch weisen Keramiken auch eine hohe Wärmeisolation auf.

Alternativ oder zusätzlich können Teile oder der gesamte Combi-Clip auch mit einem 3D-Druckverfahren hergestellt sein. Dies hat sich im Übrigen als vorteilhaft erwiesen, da im Bereich von Kontaktierungsvorrichtungen zur Übertragung elektrischer Energie eine ganze Vielzahl individueller Anforderungen an den Combi-Clip, beispielsweise im Hinblick auf dessen Größe, Dicke, sowie Bemaßungen zu stellen ist. Der Combi-Clip definiert nämlich vorzugsweise auch einen Abstand des Verbindungsgehäuses von der Leitungsschiene in zumindest eine Richtung.

Zudem ist denkbar, dass der Combi-Clip zumindest teilweise oder vollständig neben dem obig erwähnten elektrisch isolierenden Material mit metallischen oder anorganischen Teilen im Mikro- oder Nanometerbereich gebildet ist. Es hat sich nämlich herausgestellt, dass solche Nanoteilchen unter anderem auch eine höhere Festigkeit des Combi-Clips gewährleisten. Vorzugsweise ist nämlich der Combi-Clip die einzige mechanische Verbindung zwischen dem Verbindungsgehäuse und dem Verbindungsträger.

Wie nun nicht abschließend unten gezeigt, kommen zur Herstellung des Verbindungsgehäuses und/oder des Combi-Clips folgende 3D-Printtechnologien in Frage:

### 1. Das FDM-Verfahren (Fused Deposition Modeling)

### Alternativbezeichnungen: Fused Filament Fabrication (FFF), Fused Layer Modeling (FLM)

Das Verfahren bezeichnet schichtweises Auftragen (Extrusion) eines Materials durch eine heiße Düse. Das Verbrauchsmaterial befindet sich in Form eines langen Drahts (sog. Filament) auf einer Rolle und wird durch die Fördereinheit in einen Druckkopf geschoben, dort eingeschmolzen und auf einem Druckbett ausgebracht. Druckkopf und/oder Druckbett sind dabei in 3 Richtungen beweglich. So können Kunststoffschichten schrittweise aufeinander aufgebracht werden.

### 2. Das SLS Verfahren (Selektives Lasersintern)

Im Unterschied zum Sinterverfahren, bei dem Stoffe in Pulverform unter Hitzeeinwirkung miteinander verbunden werden, geschieht dies beim SLS-Verfahren selektiv durch einen Laser (alternativ auch Elektronenstrahl oder Infrarotstrahl). Es wird also nur ein bestimmter Teil des Pulvers miteinander verschmolzen.

Dazu wird stets eine dünne Pulverschicht von der Beschichtungseinheit auf dem Druckbett aufgebracht. Der Laser (oder andere Energiequelle) wird nun punktgenau auf einzelne Stellen der Pulverschicht ausgerichtet, um die erste Schicht der Druckdaten auszubilden. Hierbei wird das Pulver an- oder aufgeschmolzen und verfestigt sich anschließend wieder durch geringfügiges Abkühlen. Das nicht aufgeschmolzene Pulver bleibt um die gesinterten Bereiche herum liegen und dient als Stützmaterial. Nachdem eine Schicht verfestigt ist, senkt sich das Druckbett um den Bruchteil eines Millimeters ab. Die Beschichtungseinheit fährt nun über das Druckbett und bringt die nächste Pulverschicht auf. Anschließend wird die zweite Schicht der Druckdaten durch den Laser (oder eine andere Energiequelle) gesintert. So entsteht schichtweise ein dreidimensionales Objekt.

### 3. Three-Dimensional Printing (3DP)

Das SDP-Verfahren funktioniert sehr ähnlich wie das selektive Lasersintern, doch anstelle einer gerichteten Energiequelle verfährt ein Druckkopf über das Pulver. Dieser gibt winzige Tröpfchen von Bindemittel auf die zugrunde liegenden Pulverschichten ab, die so miteinander verbunden werden. Ansonsten ist dieses Verfahren dem SLS-Verfahren gleich.

### 4. Stereolithographie (SLA)

Anstelle eines Kunststoffdrahts oder Druckmaterials in Pulverform kommen beim Stereolithographie-Verfahren flüssige Harze, sog. Photopolymere, zum Einsatz. Sie werden schichtweise durch UV-Strahlung verhärtet und erzeugen so dreidimensionale Objekte. Dafür wird die Bauplattform im Harzbecken schrittweise abgesenkt. Es gibt auch Varianten (sog. Polyjet-Verfahren) ohne ein ganzes Becken mit flüssigem Harz. Dafür wird ein Epoxydharz tröpfchenweise aus einer Düse aufgebracht und durch einen UV-Laser sofort ausgehärtet.

### 5. Laminated Object Manufacturing (LOM)

### Alternativbezeichnung: Layer Laminated Manufacturing (LLM)

Das Verfahren basiert weder auf chemischen Reaktionen, noch auf einem thermischen Prozess. Es wird dabei mit einem trennenden Werkzeug (z.B. einem Messer oder Kohlendioxidlaser) eine Folie oder Platte (z.B. Papier) an der Kontur geschnitten und schichtweise aufeinander geklebt. So entsteht durch Absenken der Bauplattform ein Schichtobjekt aus geklebten, übereinanderliegenden Folien.

Gemäß zumindest einer Ausführungsform umfasst die hier beschriebene Abgreifvorrichtung zumindest ein Powerplug-Gehäuse, wobei das Powerplug-Gehäuse mechanisch von außen derart auf die Leitungsschiene und/oder auf die Abgreifeinrichtung aufgebracht ist, dass durch das Powerplug-Gehäuse eine mechanische Verbindung zwischen dem Verbindungsgehäuse und der Leitungsschiene hergestellt ist. Beispielsweise kann durch das Powerplug-Gehäuse neben der mechanischen Verbindung ebenso eine elektrische Verbindung zwischen dem Verbindungsgehäuse und der Leitungsschiene und/oder der Verbindungsschiene hergestellt sein.

Denkbar ist, dass das Powerplug-Gehäuse als ein leitungsendseitiges Element ausgebildet ist, welches die Abgreifeinrichtung und deren elektrische Leiter an einem ihrer Enden mit dem Verbindungsgehäuse mechanisch fest, vorzugsweise jedoch lösbar verbindet. Dazu kann das Powerplug-Gehäuse auf einer Montagefläche des Verbindungsgehäuses lösbar oder unlösbar mechanisch fixiert sein. Nach der Fixierung ist daher ein Ende der Leitungsschiene über das Verbindungsgehäuse mechanisch mit der Leitungsschiene und beispielsweise auch elektrisch leitend verbunden. Die Montagefläche ist daher vorzugsweise ein Teil der Außenfläche des Verbindungsgehäuses. Beispielsweise verläuft eine Haupterstreckungsebene der Montagefläche parallel zu der Haupterstreckungsrichtung und/oder Haupterstreckungsebene der Leitungsschiene.

Zum Beispiel kann die obig beschriebene Abgreifvorrichtung zwei "Verbindungsvorrichtungen" aufweisen, wobei eine Verbindungsvorrichtung, der obig beschriebene Combi-Clip, zur Verbindung des Verbindungsträgers mit dem Verbindungsgehäuse und eine andere, das obig beschriebene Powerplug-Gehäuse, zur Verbindung der Abgreifeinrichtung mit dem Verbindungsgehäuse dient. Die Abgreifeinrichtung kann jedoch auch mit dem Powerplug- Gehäuse und den darin verbauten Elementen identisch sein. Möglich ist jedoch auch, dass die Abgreifvorrichtung ein weiteres Verbindungsbauelement ist, welches elektrisch leitend an das Powerplug-Gehäuse montiert ist. Dieses Verbindungsbauelement kann ein oder ein Teil eines Fertigungsroboters sein.

In zumindest einer Ausführungsform, ist der hier beschriebene Combi-Clip, also das hier beschriebene Verbindungselement, zwischen dem Verbindungsgehäuse und der Leitungsschiene anstatt mittels Schraub- und/oder externer Halte- und Greifvorrichtungen zumindest maßgeblich über einen Schnappvorgang des Combi-Clips in dafür vorgesehene Bereiche des Verbindungsgehäuses und/oder des Verbindungsträgers erzeugt.

Insofern ermöglicht der hier beschriebene Combi-Clip, eine besonders individuelle, austauschbare und schnelle Verbindung zwischen dem Verbindungsgehäuse und der Leitungsschiene herzustellen. Aufwendige Anpassungsarbeiten und ebenso aufwendige Befestigungsarbeiten zur Befestigung der Leitungsschiene an dem Verbindungsgehäuse oder umgekehrt entfallen hierbei. Dies ermöglicht daher nicht nur einen ganz besonders einfachen Montageprozess, sondern auch eine ganz erhebliche Kostenersparnis, sowie eine große Bandbreite in der Serienfertigung der einzelnen Elemente und deren Anwendungsgebiete.

Gemäß zumindest einer Ausführungsform umfasst die Abgreifvorrichtung zur Übertragung elektrischer Energie von einer, vorzugsweise räumlich fixierten, Leitungsschiene auf eine entlang der Leitungsschiene bewegbaren oder ebenso räumlich fixierten Abgreifeinrichtung zumindest ein Verbindungsgehäuse, wobei über das Verbindungsgehäuse die Leitungsschiene mechanisch mit der Abgreifvorrichtung verbunden ist oder verbindbar ist, wobei eine Stromabgreifvorrichtung vorhanden ist, welche Schleifkontaktelemente zur Abnahme elektrischer Energie von der Leitungsschiene umfasst, wobei die Stromabgreifvorrichtung mechanisch fest mit dem Verbindungsgehäuse verbunden ist, wobei das Verbindungsgehäuse zumindest einen Basisträger umfasst, an dem zumindest zwei Steuerungsplatinen montiert sind oder aber diese beiden Steuerungsplatinen den Basisträger selbst ausbilden.

Gemäß zumindest einer Ausführungsform ist die mechanische Verbindung zwischen dem Verbindungsgehäuse und dem Verbindungsträger nur durch Aufklippen des Combi-Clips auf den Teil des Außenumfangs des Verbindungsgehäuses hergestellt. Vorzugsweise ist auch die Verbindung zwischen dem Combi-Clip und dem Verbindungsträger nur durch Aufklippen des Combi-Clips hergestellt.

Zumindest eine der Verbindungen (zwischen dem Combi-Clip und dem Verbindungsgehäuse einerseits und dem Combi-Clip mit dem Verbindungsträger andererseits) ist daher frei von jeglichen von dem Combi-Clip verschiedenen Befestigungselementen, wie beispielsweise Schrauben, Haftbolzen oder Spannelementen.

Mit anderen Worten bildet daher in einer solchen Ausführungsform der Combi-Clip selbst seine eigenen Halte- und Fixiermittel aus.

Gemäß zumindest einer Ausführungsform weist der Combi-Clip zum Aufklippen auf das Verbindungsgehäuse an einer Oberseite zumindest ein Oberseitenclipelement auf, wobei das Oberseitenclipelement derart ausgestaltet ist, dass sich dieses bei Beaufschlagung von Druckkraft in Richtung des Verbindungsgehäuses von selbst an den Außenumfang des Verbindungsgehäuses anlegt und/oder ein freies Ende des Oberseitenclipelementes sich an einen für dieses Ende vorgesehenen und diesem Ende eindeutig zugeordneten Befestigungsbereich des Verbindungsgehäuses verbindet.

Beispielsweise ragt das Oberseitenclipelement in zumindest einer Richtungskomponente von einer horizontalen Montageebene des Combi-Clips weg. Die Montageebene des Combi-Clips kann teilweise oder ganz durch eine, beispielweise ebene, Materialplatte gebildet sein. Die Montageebene des Clipelements ist zum Beispiel parallel zur Montageebene des Verbindungsgehäuses, auf welcher das Powerplug-Gehäuse angeordnet wird.

Beispielsweise ist das Oberseitenclipelement an einer Berandung der Montagefläche des Combi-Clips ausgebildet. Dazu ist vorstellbar, dass das Oberseitenclipelement auch randseitig vollständig bündig mit der Montagefläche des Combi-Clips abschließt. Dies gewährleistet nämlich, dass daher das Oberseitenclipelement von außen auf die Außenfläche vorzugsweise ohne Zuhilfenahme weiterer Werkzeuge allein durch Druckbeaufschlagung (Druck des Verbindungsgehäuses in Richtung des Combi-Clips) sich selbst anlegt und beispielsweise einschnappt.

Neben einem solchen randseitig angeordneten oberseitigen Clipelement kann jedoch der hier beschriebene Combi-Clip auch entlang seiner Montagefläche zumindest eines, jedoch auch mehrere weitere Oberseitenclipelemente umfassen, die abseits des Randes der Montagefläche auf der Montagefläche angeordnet sind und davon weg ragen.

Gemäß zumindest einer Ausführungsform weist der Combi-Clip zum Befestigen in einer Öffnung des Verbindungsträgers an einer der Oberseite gegenüberliegenden Unterseite zumindest ein Unterseitenclipelement auf, wobei das Unterseitenclipelement derart ausgestaltet ist, dass sich dieses bei Beaufschlagung von Druckkraft auf den Combi-Clip in Richtung des Verbindungsträgers von selbst mit einer Berandung der Öffnung in den Verbindungsträger in Eingriff bringt.

Der Verbindungsträger weist daher in zumindest einer Ausführungsform zumindest eine Öffnung oder Senke auf, in welche zumindest ein Oberseitenclipelement des Combi-Clips innenseitig einschnappen kann. Dabei kann diese Clip- und damit Schnappbewegung des Unterseitenclipelementes in der gleichen Art und Weise ausgestaltet sein, wie das obig beschriebene Oberseitenclipelement, lediglich mit dem Unterschied, dass das Oberseitenclipelement und das Unterseitenclipelement jeweils in verschiedene Richtungen von der Montagefläche des Combi-Clips weg ragen und an unterschiedlichen Seiten der Montagefläche angeordnet sind.

Gemäß zumindest einer Ausführungsform verhakt sich das Unterseitenclipelement mit der Öffnung in dem Verbindungsträger.

Insofern ist vorstellbar, dass das Unterseitenclipelement beispielsweise genauso wie das Oberseitenclipelement in Form eines Hakens ausgebildet ist. Dies heißt, dass ein solcher Haken zumindest endseitig ein Verhakelement aufweist. Es hat sich nämlich herausgestellt, dass ein derartiges Verhaken ein ganz besonders einfaches und selbsttätiges Verhaken werkzeugfrei ermöglicht.

Gemäß zumindest einer Ausführungsform ist das Powerplug-Gehäuse zumindest teilweise an einer Seite offen, wobei das Powerplug-Gehäuse an dieser Seite zumindest ein Powerplug-Clipelement aufweist und wobei das Powerplug-Clipelement derart ausgestaltet ist, dass sich dieses bei Beaufschlagung von Druckkraft in Richtung des Verbindungsgehäuses von selbst an dem Außenumfang des Verbindungselementes anlegt und/oder ein freies Ende des Powerplug-Clipelementes sich an einem für dieses Ende vorgesehenen und an diesem Ende eindeutig zugeordneten weiteren Befestigungsbereich und des Verbindungsgehäuses verbindet, wobei somit zwischen dem Verbindungsgehäuse und einer Innenwand des Powerplug-Gehäuses zumindest ein Teil der vorzugsweise räumlich fixierten Leitungsschiene angeordnet ist.

In einer derartigen Ausführungsform ist es daher denkbar, dass das Powerplug-Gehäuse, beispielsweise anstatt auf einer Montagefläche des Verbindungsgehäuses angeordnet zu sein, mittels zumindest eines randseitig angeordneten Powerplug-Clipelementes in dafür vorgesehene Befestigungsstellen des Verbindungsgehäuses eingreift.

Gemäß zumindest einer Ausführungsform umfasst das Verbindungsgehäuse zumindest ein elektrisch leitendes Schleifkontaktelement, wobei dieses Schleifkontaktelement einerseits mit einer elektrischen Platine des Verbindungsgehäuses und andererseits über eine Schleifkontaktierung mit der Leitungsschiene elektrisch leitend verbunden ist.

Insbesondere kann das Schleifkontaktelement in Form einer Biegefeder ausgebildet sein. Dazu kann jedes Schleifkontaktelement auch zwei oder mehrere Biegungen aufweisen, mittels derer ein elektrisch leitender Kontakt mit einer Leitung der Leitungsschiene in der obigen Art hergestellt ist.

Über den beispielsweise vorhandenen Biegeabschnitt und dessen vorzugsweise spitzen Winkel relativ zu der Leitung der Leitungsschiene wird es daher ermöglicht, dass das Basiselement unter Druck, d.h. unter einer Federquetschung derart eingebaut und an dem Verbindungsgehäuse und an der Platine montiert wird, dass ein mechanischer und vorzugweise elektrischer, dauerhafter Kontakt zwischen dem Schleifkontaktelement und der Leitungsschiene und/oder der Abgreifeinrichtung hergestellt ist.

Gemäß zumindest einer Ausführungsform ist das Schleifkontaktelement einstückig ausgebildet. Dies kann heißen, dass das Schleifkontaktelement in einem einzigen Element durchgehend, beispielsweise von einem elektrisch leitenden Metall, gebildet ist. Das Schleifkontaktelement kann daher frei von Verbindungsnuten und/oder Verbindungsschrauben sein. Insbesondere kann das Schleifkontaktelement in einem einzigen Fertigungsprozess aus einem einzigen Metallstück gebildet sein.

Gemäß zumindest einer Ausführungsform sind die Steuerungsplatinen jeweils dazu eingerichtet und dafür vorgesehen, zumindest einen elektrischen Motor anzutreiben, zu steuern und/oder zu regeln.

Eine Leiterplatte (Leiterkarte, Platine oder gedruckte Schaltung; englisch: *printed circuit board, PCB*) ist ein Träger für elektronische Bauteile. Sie dient der mechanischen Befestigung und elektrischen Verbindung. Nahezu jedes elektronische Gerät enthält eine oder mehrere Leiterplatten.

Leiterplatten bestehen aus elektrisch isolierendem Material mit daran haftenden, leitenden Verbindungen (Leiterbahnen). Als isolierendes Material ist faserverstärkter Kunststoff üblich, bei günstigeren Geräten Hartpapier. Die Leiterbahnen werden zumeist aus einer dünnen Schicht Kupfer, üblich sind 35µm oder 70µm, geätzt. Die Bauelemente werden auf Lötflächen (Pads) oder in Lötaugen gelötet. So werden sie an diesen footprints gleichzeitig mechanisch gehalten und elektrisch verbunden. Größere Komponenten können auch mit Kabelbindern, Klebstoff oder Verschraubungen auf der Leiterplatte befestigt werden.

Gemäß zumindest einer Ausführungsform weisen die Steuerungsplatinen jeweils eine Spannungsaufnahme von wenigstens 16 Volt und höchstens 56 Volt, vorzugweise wenigstens 24 Volt und höchstens 48 Volt, auf. Vorzugsweise ist die Steuerungsplatinen auch nur für diesen Voltbereich eingerichtet und vorgesehen. Zum Beispiel umfasst das Verbindungsgehäuse eine Überstrom-Schutzschaltung, die dafür sorgt, dass der Motor vor höheren Spannungen geschützt ist. Alternativ oder zusätzlich kann auch ein solcher Motor verbaut sein, welcher oberhalb der Höchstspannung nicht betreibbar ist, etwa weil der Motor durchbrennen würde.

Zum Beispiel weist die Leitungsschiene eine 24V-, sowie eine 48V-Leitung auf, wobei zu jeder der beiden Leitungen jeweils eine GND Leitung als Erdung angeordnet ist. Die Leitungsschiene kann in diesem Beispiel insgesamt vier Leitungen umfassen, die jeweils parallel zueinander verlaufen.

Denkbar ist, dass eine der beiden Leitungen (24V oder 48V) zur Spannungsversorgung des Motors oder der Steuerungsplatinen dient, während die jeweils andere Leitung mittels Durchkontaktierungen in dem Basisträger als eine Anschlussenergieversorgung für das PowerPlug-Gehäuse und einen an dieses dann angeschlossenen Nutzungsgegenstands (zum Beispiel einem Roboter) dient.

Zum Beispiel handelt es sich bei dem elektrischen Motor um einen solchen Motor, der mittels eines Antriebsritzels die gesamte Verbindungsvorrichtung entlang der Leitungsscheine antreibt. Das Antriebsritzel kann dabei in mechanischer Wirkverbindung mit einer Eingreifschiene sein. Die Eingreifschiene kann parallel zur Leitungsschiene verlaufen. Das Antriebsritzel kann dann Teil der Verbindungsvorrichtung sein.

Gemäß zumindest einer Ausführungsform sind die Schleifkontaktelemente durch eine erste Anzahl von ersten Kontaktelementen zur Leistungsversorgung mit zumindest einer ersten Spannung einer der Motorcontrollerplatinen, sowie durch eine zweite Anzahl von Kontaktelementen zur Leistungsversorgung mit zumindest einer zweiten Spannung einer anderen Motorcontrollerplatine gebildet, wobei somit zumindest zwei Kontaktelementgruppen gebildet sind. Dabei sind die einzelnen Kontaktelemente jeder Gruppe hintereinander in einer Verfahrrichtung des Verbindungsgehäuses angeordnet und jede Gruppe ist separat mittels einer ihr eindeutig zugeordnete Motorcontrollerplatine mit elektrischer Leistung versorgt, insbesondere wobei die Kontaktelemente in einer zur Verfahrrichtung senkrechten Richtung zwischen den Kontaktelementen und den Kontaktelementen als eine Erdung (GND-Anschluss) ausgebildet sind.

Gemäß zumindest einer Ausführungsform weist die Stromabgreifvorrichtung zumindest ein, vorzugsweise genau ein, weiteres Schleifkontaktelement auf, wobei mittels dieses weiteren Schleifkontaktelements zumindest eine der Motorcontrollerplatinen mit elektrischer Leistung versorgbar ist.

Gemäß zumindest einer Ausführungsform ist das weitere Schleifkontaktelement in der Verfahrrichtung zwischen zwei der Schleifkontaktelemente der Kontaktelemente angeordnet.

Gemäß zumindest einer Ausführungsform sind die Kontaktelemente der ersten Gruppe 48 Volt Kontaktanschlüsse und die Kontaktelemente der zweiten Gruppe 24V Kontaktanschlüsse.

Zum Beispiel ist das weitere Schleifkontaktelement mit einer der beiden Steuerungsplatinen elektrisch leitend verbunden. Insbesondere dient das weitere Schleifkontaktelement zur Vergrößerung einer Kontaktfläche für eine oder beide der Platinen. Es kann damit einer oder beide Motoren besser mit Strom versorgt werden.

Gemäß zumindest einer Ausführungsform ist das weitere Schleifkontaktelement als eine 48 Volt Spannungsaufnahme oder eine 24 Volt Spannungsaufnahme ausgebildet und/oder mit einer 48V Spannungsaufnahme oder 24V Spannungsaufnahme einer der Steuerungsplatinen elektrisch leitend verbunden.

Erfindungsgemäß sind die beiden Steuerungsplatinen in einer Richtung senkrecht zu der Verfahrrichtung übereinander, also gestackt, angeordnet.

Des Weiteren betrifft die vorliegende Erfindung ein Abgreifvorrichtungssystem zur Übertragung elektrischer Energie von einer, vorzugsweise räumlich fixierten, Leitungsschiene an eine entlang der Leitungsschiene bewegbare oder ebenso räumlich fixierte Abgreifvorrichtung, wobei entlang der Leitungsschiene an einer Verbindungsvorrichtung hintereinander zumindest zwei Abgreifvorrichtungen gemäß zumindest einer der oben beanspruchten Ausführungsformen angeordnet sind.

Grundsätzlich kommen als Materialien für das Verbindungsgehäuse und/oder den Combi-Clips die folgenden nicht abschließend aufgezählten Materialien in Frage:

| **Werkstoffgruppe** | **Modifikation** | **SHORE D** |
|---|---|---|
| **ABS** | | 75 - 93 |
| | ABS + 30 M.-% GF | 62-68 |
| | ABS / TPE | 46 |
| | ABS / TPU | 58-68 |
| **ASA** | | 75 |
| **ETFE** | | 60-78 |
| **EVA** | | 17-45 |
| **PA 11** | PA 11 + 23 M.-% GF | 70 |
| **PA 12** | PA 12 (normfeucht) | 75 - 78 |
| | PA 12 + 30 M.-% GF (normfeucht) | 75 |
| **PA 612** | | 73 |
| **PA 6** | PA 6 (normfeucht) | 52-77 |
| | PA 6 + 30 M.-% GF | 48 - 80 |
| | PA 6 + 30 M.-% GF (trocken) | 84 |
| **PA 66** | PA 66 + 30 M.-% GF | 77 - 82 |
| | PA 66 + 30 M.-% GB | 81 |
| | PA 66 + 30 M.-% MX | 75 - 82 |
| **PAEK** | | 86-90 |
| | PAEK + 30 M.-% GF | 90 |
| **PBI** | | 99 |
| **PBT** | | 79 - 86 |
| | PBT + 30 M.-% GF | 53 - 85 |
| | PBT + 30 M.-% GX | 54 |
| **PC** | | 51 - 85 |
| | PC + 30 M.-% GF | 65 - 72 |
| | PC + 30 M.-% GX | 70 |
| **PCTFE** | | 76 - 80 |
| **PE-HD** | | 56 - 69 |
| **PE-LD** | | 39 - 83 |
| **PE-LLD** | | 38-60 |
| **PE-MD** | | 45 - 60 |
| **PE-UHMW** | | 60 - 65 |
| **PEEK** | | 83 - 88 |
| **PEI** | | 88-90 |
| **PEK** | | 87 |
| | PEK + 30 M.-% GF | 90 |
| **PET** | PET + 30 M.-% GF | 63 - 65 |
| **PMMA** | | 52 - 85 |
| | PMMA + 30 M.-% GF | 55 |
| **POM** | | 52 - 83 |
| **PP** | | 59-77 |
| | PP + 30 M.-% GF | 62-80 |
| | PP + 30 M.-% CD | 74-75 |
| | PP + 30 M.-% MF | 60-74 |
| | PP + 30 M.-% P | 65 |
| | PP + 30 M.-% CaCO₃ | 55 - 70 |
| | PP / EPDM | 40 |
| **PS** | | 78 - 80 |
| **PTFE** | | 50-90 |
| **PUR** | | 20 - 84 |
| **PVC-U** | | 74 - 94 |
| | PVC-U / NBR | 58-74 |
| **PVC-P** | | 42 - 77 |
| **PVC-C** | | 82 |
| **PVDF** | | 46 - 79 |
| **SAN** | | 45 - 85 |
| **SMMA** | | 72 - 82 |
| **TPC** | | 28 - 82 |
| **TPE** | | 48 - 78 |
| | TPE / PTFE | 56 |
| **TPE-E** | TPE-E + 30 M.-% GF | 55 |
| **TPO** | | 16-70 |
| **TPS** | | 60 |
| **TPU** | TPU + 30 M.-% GF | 74-80 |
| **TPV** | | 40-51 |

wobei gilt:
GF: Glasfasern
GB: Glaskugeln
MF: Mineralfasern
MX: nicht spezifizierte Mineralfüllung
GX: nicht spezifizierte Glasfüllung
CD: Kohlenstoffmehl
P: nicht spezifiziertes Füllmehl

Gemäß zumindest einer Ausführungsform ist ein Material-Shore D-Härtewert des Combi-Clips um zumindest zwei, bevorzugt um zumindest vier, Härtewerte größer als ein Material-Shore D-Härtewert des Verbindungsgehäuses. Dabei können beide Bauteile mit dem gleichen Grundmaterial gebildet sein, in welches Weich- oder Hartmacher eingemischt sind. Auch solche Weich- und Hartmacher sind der obigen Tabelle zu entnehmen.

Dies erleichtert nicht nur das Aufschnappen des Combi-Clips auf das Verbindungsgehäuse, sondern garantiert auch eine stabile Führung des Combi-Clips entlang der Leitungsschiene.

Zum Beispiel sind der Combi-Clip mit ABS und das Verbindungsgehäuse mit PA6 gebildet, wie der oben stehenden Tabelle entnehmbar ist.

Ebenso ist es jedoch möglich, dass der Combi-Clip und das Verbindungsgehäuse mit dem gleichen Material gebildet sind. Bei dem Material kann es sich um PC oder um ABS handeln.

In den Combi-Clip und/oder das Verbindungsgehäuse (oder zumindest in eine Unterschicht davon) können wenigstens abschnittsweise eine Vielzahl von zusätzlichen Körpern, insbesondere von im Wesentlichen kugelförmigen Körpern, wie insbesondere Mikroglaskugeln, eingearbeitet sein. Auf diese Weise wird die mechanische Belastbarkeit erhöht und auch der Reibwert, an einer Führung für das Verbindungsgehäuse stark herabgesetzt.

So ist es möglich, dass die Oberflächenstruktur des Materials durch eine Vielzahl von kugelförmigen Elementen gebildet wird. Vorteilhaft sind dabei diese Elemente, insbesondere kugelförmigen Elemente, aus einem Material hergestellt, welches aus einer Gruppe von Materialien ausgewählt ist. Dieses enthält Glas- oder Keramikkugeln und dergleichen, vorzugsweise aber unipolare Füllstoffe.

Vorteilhaft weisen dabei diese zusätzlichen Körper, beispielsweise kugelförmigen Körper jeweils Querschnitte bzw. Volumina auf, die einen Durchmesser kleiner 1 mm, vorzugsweise kleiner 0,1 mm und besonders vorzugsweise kleiner 0,01 mm aufweisen.

Vorteilhaft beträgt ein Gewichtsanteil dieser kugelförmigen Körper gegenüber dem Gesamtmaterial mehr als 5 %, vorzugsweise mehr als 10 % und besonders vorzugsweise mehr als 20 %.

Anstelle von kugelförmigen Körpern können auch im Wesentlichen kugelförmige Körper, beispielsweise ellipsenartige Körper vorgesehen sein.

Weitere Vorteile und Ausführungsformen ergeben sich aus den beigefügten Zeichnungen:
Darin zeigen:
Die Figuren 1A bis 1D verschiedene perspektivische Ansichten eines Ausführungsbeispiels der hier beschriebenen Abgreifvorrichtung 100.

Die Figuren 2A und 2B zeigen in verschiedenen perspektivischen Ansichten ein Ausführungsbeispiel einer hier beschriebenen Stromabgreifvorrichtung oder Abgreifvorrichtung 100, sowie ein Ausführungsbeispiel eines hier beschriebenen Combi-Clips der Abgreifvorrichtung.

Die Figur 3 zeigt eine schematisch perspektivische Schnittdarstellung durch die hier beschriebene Abgreifvorrichtung 100.

Die Figur 4 zeigt in einer schematisch perspektivischen Ansicht Lichtleitelemente der Abgreifvorrichtung 100.

Die Figuren 5A und 5B zeigen seriell in Reihe zueinander geschaltete Abgreifvorrichtungen 100, sodass in den Figuren 5A und 5B in schematisch perspektivischer Ansicht jeweils ein Ausführungsbeispiel eines hier beschriebenen Abgreifvorrichtungssystems 1000 dargestellt ist.

Die Figur 6 zeigt einen schematischen Verschaltungsplan zweier Steuerungsplatinen 100A einer hier beschriebenen Abgreifvorrichtung 100.

Die Figur 7 zeigt schematisch jeweils Informations- bzw. Schaltverbindungen zwischen einem 24 V Anschluss der Leitungsschiene 1 bzw. einem 48 V Anschluss der Leitungsschiene 1.

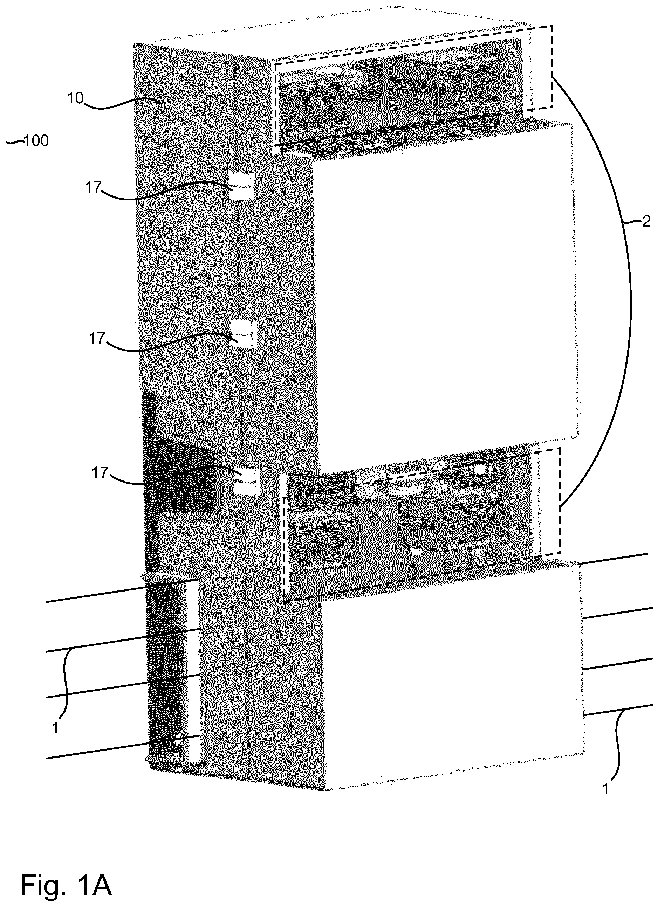

In der Figur 1A ist in einer schematisch perspektivischen Ansicht ein Ausführungsbeispiel einer erfindungsgemäßen Abgreifvorrichtung 100 zur Übertragung elektrischer Energie von einer vorzugsweise räumlich fixierten Leitungsschiene 1 auf eine entlang der Leitungsschiene 1 bewegbare oder ebenso räumlich fixierte Abgreifeinrichtung 2.

Dabei ist aus der Figur 1A erkennbar, dass die Abgreifvorrichtung 100 zunächst ein Verbindungsgehäuse 10 aufweist, wobei das Verbindungsgehäuse 10 mit einer Leitungsschiene 1 mechanisch mit einer Abgreifeinrichtung 2 verbunden ist.

Die Abgreifeinrichtung 2 ist jedoch in der Figur 1A nur gestrichelt dargestellt, sodass die verschiedenen Steckerelemente nicht durch die Abgreifeinrichtung 2 verdeckt sind.

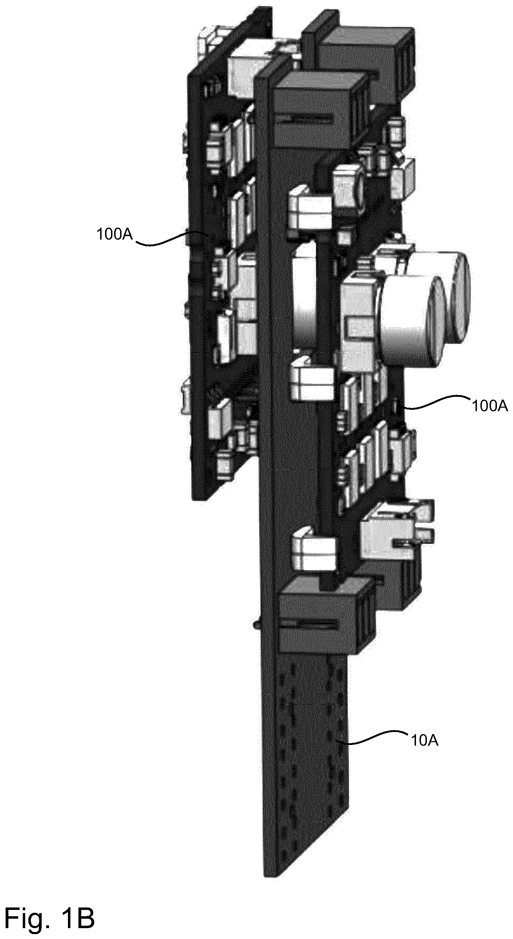

Erfindungsgemäß weist nämlich die Abgreifvorrichtung 100 wie in der Figur 1B dargestellt, einen Basisträger 10A auf, an welchem mechanisch fest, vorzugsweise jedoch lösbar, zwei Steuerungsplatinen 100A montiert sind. Bei dem Basisträger 10A kann es sich um eine DI/DO-Platine handeln.

Wie sowohl in der Figur 1A, als auch aus der Figur 1B dargestellt, weist daher der Basisträger 10A zwei DI-Stecker, sowie zwei DO-Stecker auf. Zusätzlich kann die Basisplatte 10A zwei Motorstecker aufweisen. Diese Motorstecker können jedoch ebenso auch in die Steuerungsplatinen 100A integriert sein. Zum Beispiel weist jede Steuerungsplatine 100A einen Motorstecker auf.

Zudem sind in der Figur 1A Lichtleiter 17 erkennbar, welche in optisch von außen einsehbarer Art und Weise eine Funktions- und Zustandskontrolle der einzelnen Bauelemente der Steuerungsplatinen 100A und/oder des Basisträgers 10A darstellt.

Insofern unterscheiden sich die Darstellung der Figur 1A und 1B lediglich dadurch, als dass aus Vereinfachungsgründen weder die Abgreifvorrichtung 2 noch das Verbindungsgehäuse 10 dargestellt ist, sodass die übereinander arrangierten Steuerungsplatinen 100A, sowie der zwischen den beiden Steuerungsplatinen 100A angeordnete Basisträger 10A frei einsehbar ist.

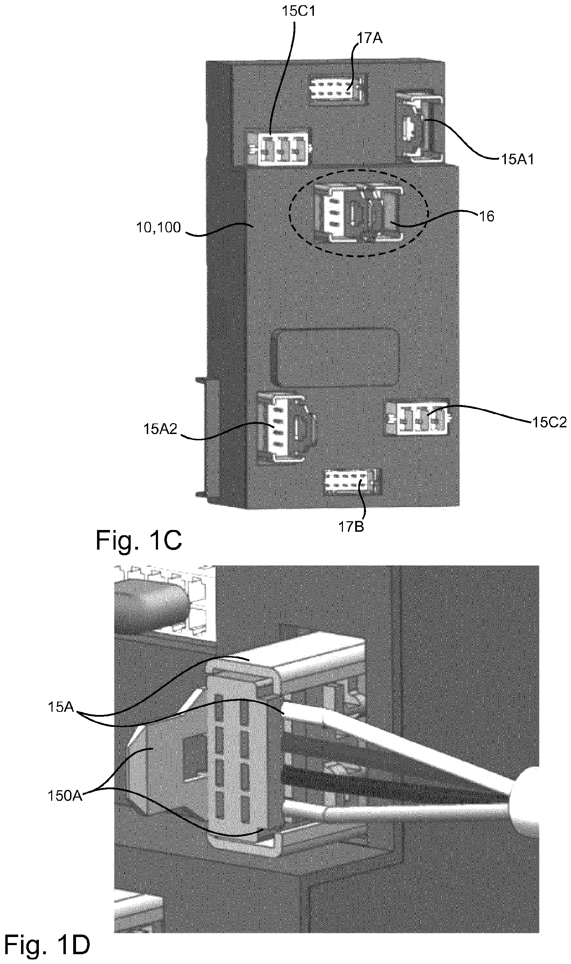

Der Figur 1C ist ebenso die in den Figuren 1A bis 1B gezeigte Abgreifvorrichtung 100 entnehmbar, wobei das Verbindungsgehäuse 10 bis auf die Steckeröffnungen für die Stecker 15A bis 17B vollständig geschlossen gezeigt ist.

Erkennbar sind Stecker 15A1 und 15A2 als DI-Stecker, sowie Stecker 15C1 und 15C2 als DO-Stecker. Dabei sind die Stecker 17A und 17B jeweils Stecker für anzuschließende Motoren. Der Stecker 16 ist ein CAN/DAISY Stecker zum Anschluss eines CAN/DAISY Busses/Anschlusses.

Der Figur 1D ist in einer schematisch perspektivischen Ansicht eine vergrößerte Ansicht des Steckers 15A (zum Beispiel ein DI-Stecker) entnehmbar, dass der dort dargestellte Stecker 15A eine Verriegelung 150A aufweist, durch welche die Kabelverbindungen insbesondere von der Seite in den Stecker 15A eingesteckt werden können.

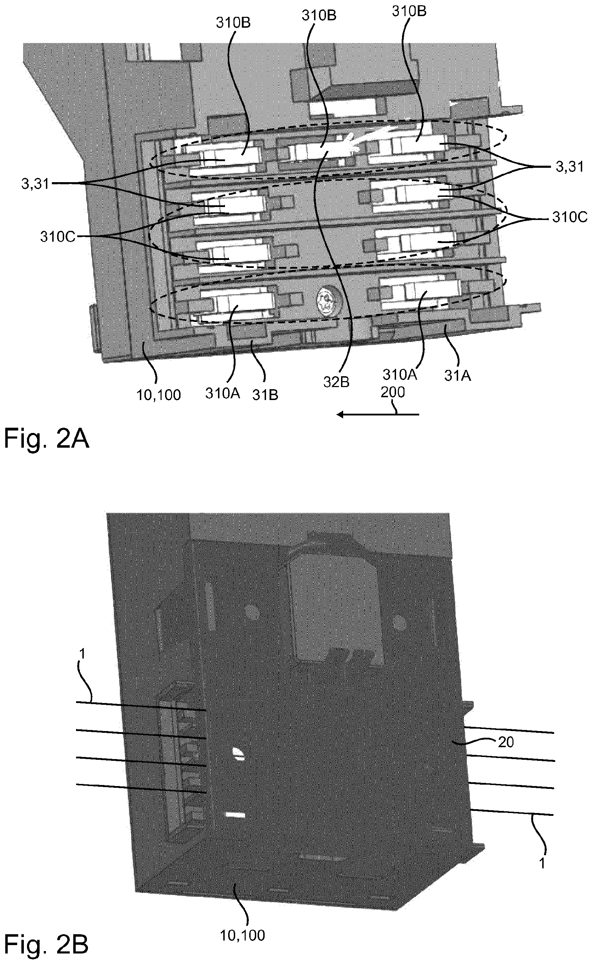

In der Figur 2A ist in einer schematisch perspektivischen Ansicht wiederum zwar die hier beschriebene Abgreifvorrichtung 100 ausschnittsmäßig dargestellt, jedoch ist nunmehr die Stromabgreifvorrichtung 3 dargestellt, welche Schleifkontaktelemente 31 zur Abnahme elektrischer Energie von der Leitungsschiene 1 umfasst, wobei die Stromabgreifvorrichtung 3 fest mit dem Verbindungsgehäuse 10 verbunden ist.

Des Weiteren sind die Schleifkontaktelemente 31 in insgesamt drei Schleifkontaktgruppen 310A, 310B und 310C unterteilt.

Die Schleifkontaktgruppe 310A ist diejenige, welche 24V abgreift, die Schleifkontaktgruppe 310B ist diejenige, welche 48V abgreift und die Schleifkontaktgruppe 310C ist die Erdung GND. Dabei ist erkennbar, dass ein weiteres Schleifkontaktelement 32B ebenso ein 48V Schleifkontakt zur Vergrößerung der Kontaktfläche ist, damit, aufgrund der höheren Leistungsanforderung, zwei Motoren gleichzeitig ausreichend mit Strom versorgt werden können.

Zudem sind alle Schleifkontaktgruppen (48V, GND, 24V) auf dem Basisträger 10A gebrückt.

In der Figur 2B ist eine schematische Rückansicht der unter anderem in der Figur 1C dargestellten Abgreifvorrichtung 100 gezeigt. Erkennbar ist hier, wie bereits in der Figur 1C angedeutet, ein Combi-Clip 20, welcher rückseitig von außen mittels vorhandener Clipselemente auf den Außenumfang des Verbindungsgehäuses 10 aufgeklipst ist, sodass in einem dann gebildeten Hohlraum sich die Schleifkontaktelemente 31 befinden, sodass zwischen dem Combi-Clip 20 und den Schleifkontaktelementen 31 die Leitungsschiene 1 verlegt ist.

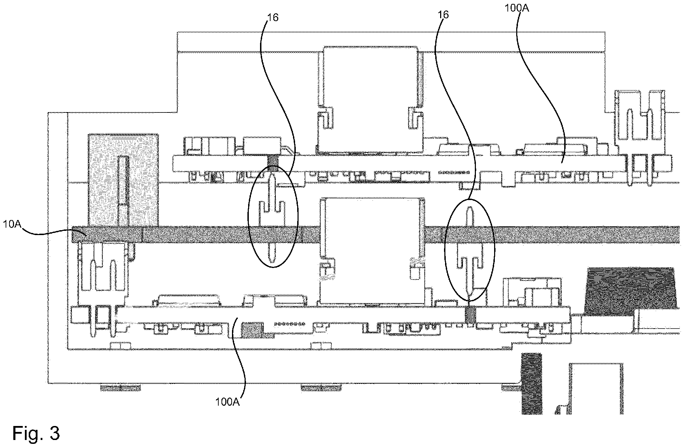

In der Figur 3 ist eine schematische Schnittansicht der hier beschriebenen Abgreifvorrichtung 100 gemäß der vorhergehenden Figuren 1A bis 2B gezeigt, wobei erkennbar ist, dass mittels einer Platinenbefestigung 16 der Basisträger 10A mit einer unteren Steuerungsplatine 100A befestigt ist.

Selbiges gilt ebenso für die obere Steuerungsplatine 100A, welche mittels einer weiteren Platinenbefestigung 16 an dem Basisträger 10A befestigt ist. Die Platinenbefestigungen können in Form von Stiftleisten ausgebildet sein. Diese können in entsprechende Bohrungen in den Steuerungsplatinen 100A verlötet sein.

Insbesondere kann so gewährleistet sein, dass die Steuerungsplatinen 100A mindestens 40 N Zug- und Hubkräfte bei zumindest zehnmaligem Aus- und Einstecken der Abgreifeinrichtung 2 ohne Materialbeschädigung überstehen können.

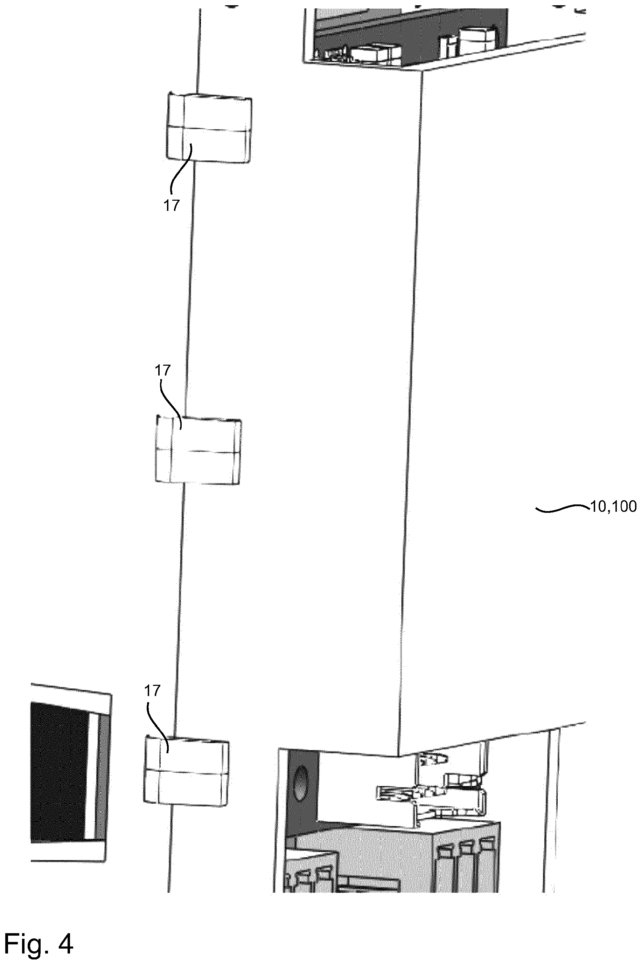

Der Figur 4 ist nochmals in schematisch perspektivischer Ansicht der bereits in der Figur 1A dargestellte Lichtleiter 17 entnehmbar.

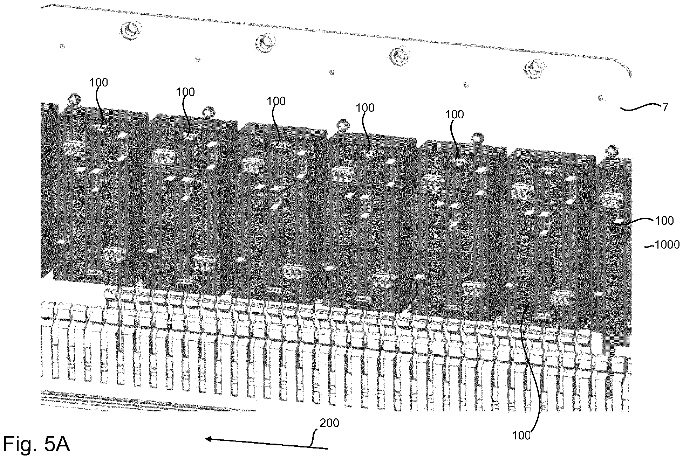

Der Figur 5A ist ein Ausführungsbeispiel eines hier beschriebenen Abgreifvorrichtungssystems 1000 entnehmbar, wobei die einzelnen Abgreifvorrichtungen 100, wie in den vorgenannten Figuren gezeigt, mittels einer Verbindungsvorrichtung 7, welche vorliegend in Form einer Verbindungsplatte ausgebildet ist, miteinander in Serie geschaltet, zumindest jedoch hintereinander angeordnet sind.

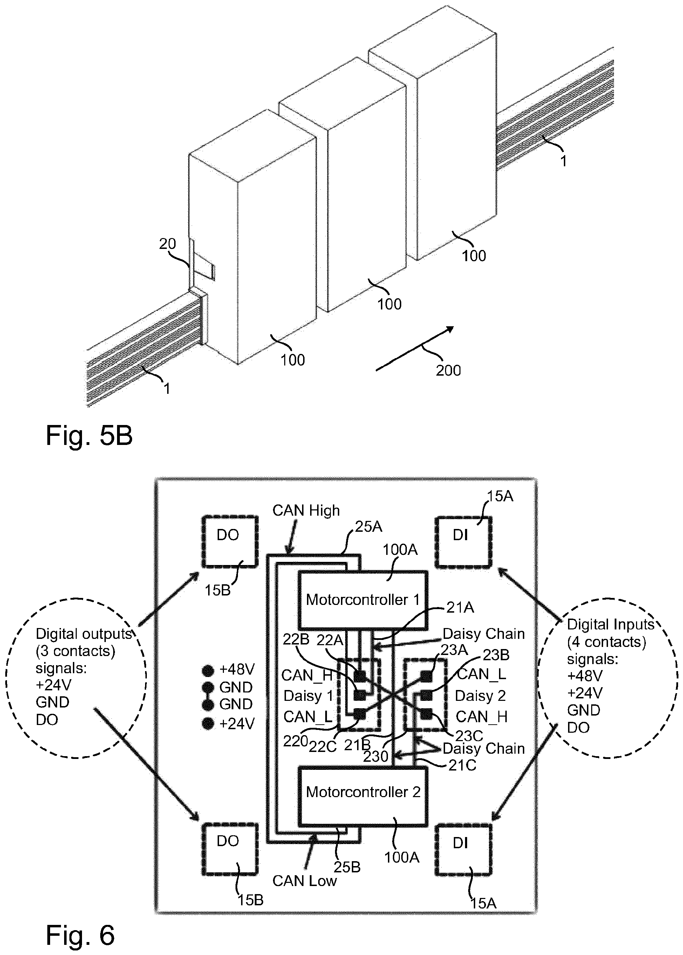

Die Figur 5B zeigt in schematisch perspektivischer Ansicht nochmal die Hintereinanderanordnung der einzelnen Abgreifvorrichtungen 100, zum Beispiel in Verfahrrichtung 200, wobei hier der Combi-Clip 20 einer jeden Abgreifvorrichtung 100 nochmal erkennbar ist.

Dabei kann das Verbindungsgehäuse 10 in Form eines Quaders ausgebildet sein, mit Kantenlängen einer Breite des Verbindungsgehäuses 10 von wenigstens 40 mm bis höchstens 70 mm, einer Höhe von wenigstens 80 mm und höchstens 120 mm, sowie einer Tiefe von wenigstens 20 mm und höchstens 50 mm.

In der Figur 6 sind ein Prinzipaufbau, sowie eine Verschaltung der einzelnen Steuerungsplatinen 100A, insbesondere der einzelnen Controller der Steuerungsplatinen 100A, gezeigt.

Erkennbar ist, dass die einzelnen Controller über Daisy Chains 21A, 21B, 21C in Reihe zueinander verschaltet sind. Insbesondere ist jedoch auch erkennbar, dass ein Anschluss 22A (CAN H-Anschluss), ein Anschluss 22B (Daisy 1-Anschluss) und ein Anschluss 22C (CAN L-Anschluss) vorhanden sind und ein daher mit gestrichelten Linien umrahmtes Anschlusssystem 220 gebildet ist.

Dieses Anschlusssystem 220 ist einer der Steuerungsplatinen 100A zugeordnet und/oder auf dieser angeordnet, während ein weiteres Anschlusssystem 230 der anderen Steuerungsplatine 100A zugeordnet ist. Das Anschlusssystem 230 ist in der gleichen Art und Weise wie das Anschlusssystem 220 aufgebaut und ist entsprechend lediglich nur mit der anderen Steuerungsplatine 100A elektrisch leitend verbunden. Insofern weist auch das Anschlusssystem 230 einen Stecker 23A (CAN L-Anschluss), einen Stecker 23B (Daisy 2-Anschluss) und einen Stecker 23C (CAN H-Anschluss) auf.

Zudem sind elektrische Leit- und/oder Informationsverbindungen 25A (CAN High-Verbindungen) und 25B (CAN Low-Verbindung) dargestellt.

Die Stecker 15B sind daher digitale Outputstecker (DO-Stecker), welche zum Beispiel jeweils drei Kontakte aufweisen, an denen eine Spannung von 24 V anlegbar ist oder anliegt.

Die Stecker 15A sind digitalen Inputstecker (DI-Stecker), an welche zum Beispiel wahlweise 24 V und/oder 48 V anlegbar sind.

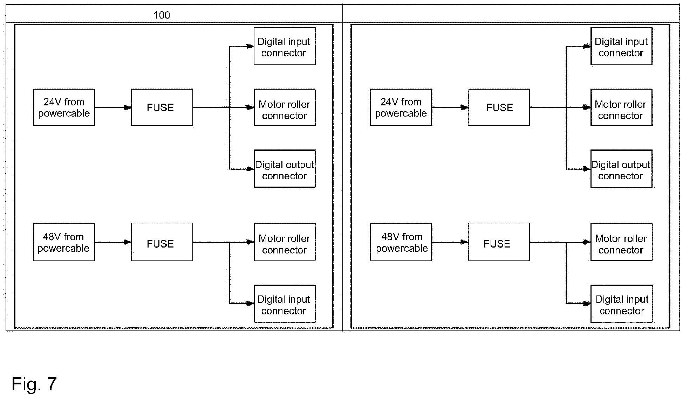

In der Figur 7 sind Basisinformationsflussdiagramme gezeigt, welche eine Spannungsabnahme von einer 24 V Leitung der Leitungsschiene 1, sowie einer 48 V Leitung der Leitungsschiene 1 zeigen. Bei der 24 V Spannungsabnahme sind sowohl DI- als auch DO-Stecker leitungsmäßig mit der 24 V Abnahme verbunden, während mit der 48 V Abnahme lediglich ein DI-Stecker verbunden ist.

Jedenfalls sind die einzelnen Abgreifvorrichtungen 100 vorzugsweise identisch miteinander verschaltet.

### Bezugszeichenliste

- 1: Leitungsschiene
- 2: Abgreifeinrichtung
- 3: Stromabgreifvorrichtung
- 7: Verbindungsvorrichtung
- 10: Verbindungsgehäuse
- 10A: Basisträger
- 15A: Stecker
- 15A1: Stecker
- 15A2: Stecker
- 15B: Stecker
- 15C1: Stecker
- 15C2: Stecker
- 16: Platinenbefestigung
- 17: Lichtleiter
- 17A: Stecker
- 17B: Stecker
- 20: Combi-Clip
- 21A: Daisychains
- 21B: Daisychains
- 21C: Daisychains
- 22A: CANH-Anschluss
- 22B: Daisy1-Anschluss
- 22C: CANL-Anschluss
- 23A: CANL-Anschluss
- 23B: Daisy2-Anschluss
- 23C: CANH-Anschluss
- 25A: Leit- und/oder Informationsverbindungen (CAN High-Verbindung)
- 25B: Leit- und/oder Informationsverbindungen (CAN Low-Verbindung)
- 31: Schleifkontaktelemente
- 32B: weiteres Schleifkontaktelement
- 100: Abgreifvorrichtung
- 100A: Steuerungsplatine
- 150A: Verriegelung
- 200: Verfahrrichtung
- 220: Anschlusssystem
- 230: Anschlusssystem
- 310A: Schleifkontaktgruppe
- 310B: Schleifkontaktgruppe
- 310C: Schleifkontaktgruppe
- 1000: Abgreifvorrichtungssystem

## Patentansprüche

1. Abgreifvorrichtung (100) zur Übertragung elektrischer Energie von einer räumlich fixierten Leitungsschiene (1) auf eine entlang der Leitungsschiene (1) bewegbare oder ebenso räumlich fixierte Abgreifeinrichtung (2), umfassend:
- zumindest ein Verbindungsgehäuse (10), wobei über das Verbindungsgehäuse (10) die Leitungsschiene (1) mechanisch mit der Abgreifeinrichtung (2) verbindbar ist,
- eine Stromabgreifvorrichtung (3), welche Schleifkontaktelemente (31) zur Abnahme elektrischer Energie von der Leitungsschiene (1) umfasst, wobei die Stromabgreifvorrichtung (3) mechanisch fest mit dem Verbindungsgehäuse (10) verbunden ist,
- **dadurch gekennzeichnet, dass**
das Verbindungsgehäuse (10) zumindest einen Basisträger (10A) umfasst, an dem eine obere Steuerungsplatine (100A) und eine untere Steuerungsplatine (100A) montiert sind, wobei der Basisträger (10A) zwischen den beiden Steuerungsplatinen (100A) montiert ist, und somit die beiden Steuerungsplatinen (100A) in einer Richtung senkrecht zu einer Verfahrrichtung (200) übereinander, also gestackt, angeordnet sind.

2. Abgreifvorrichtung (100) nach Anspruch 1,
**dadurch gekennzeichnet, dass**
die Steuerungsplatinen (100A) jeweils dazu eingerichtet und dafür vorgesehen sind, zumindest einen elektrischen Motor anzutreiben, zu steuern und/oder zu regeln.

3. Abgreifvorrichtung (100) nach Anspruch 1 oder 2,
**dadurch gekennzeichnet, dass**
die Steuerungsplatinen (100A) zumindest eine Spannungsaufnahme von +24V und/oder +48V aufweisen.

4. Abgreifvorrichtung (100) nach einem der vorhergehenden Ansprüche,
**dadurch gekennzeichnet, dass**
die Schleifkontaktelemente (31) durch eine erste Anzahl von ersten Kontaktelementen (310A) zur Leistungsversorgung mit zumindest einer ersten Spannung einer der Steuerungsplatinen (100A) gebildet ist, sowie eine zweite Anzahl von Kontaktelementen (310B) zur Leistungsversorgung mit zumindest einer zweiten Spannung einer anderen Steuerungsplatine (100A) gebildet ist, wobei somit zumindest zwei Kontaktelementgruppen gebildet sind, wobei die einzelnen Kontaktelemente (310A, 310B) jeder Gruppe hintereinander in einer Verfahrrichtung (200) des Verbindungsgehäuses (10) angeordnet sind und jede Gruppe separat eine ihr eindeutig zugeordnete Steuerungsplatine (100A) mit elektrischer Leistung versorgt, wobei Kontaktelemente (310C) in einer zur Verfahrrichtung (200) senkrechten Richtung zwischen den ersten Kontaktelementen (310A) und den zweiten Kontaktelementen (310B) als eine Erdung (GND-Anschluss) ausgebildet sind.

5. Abgreifvorrichtung (100) nach Anspruch 4,
**dadurch gekennzeichnet, dass**
die Stromabgreifvorrichtung (3) zumindest ein weiteres Schleifkontaktelement (32B) aufweist, wobei mittels dieses weiteren Schleifkontaktelements (32B) zumindest eine der Steuerungsplatinen (100A) mit elektrischer Leistung versorgbar ist.

6. Abgreifvorrichtung (100) nach Anspruch 5,
**dadurch gekennzeichnet, dass**
das weitere Schleifkontaktelement (32B) in der Verfahrrichtung (200) zwischen zwei der Schleifkontaktelemente (31) der ersten Kontaktelemente (310A) angeordnet ist.

7. Abgreifvorrichtung (100) nach einem der vorhergehenden Ansprüche 4 bis 6,
**dadurch gekennzeichnet, dass**
die zweiten Kontaktelemente (310B) 48V Kontaktanschlüsse und die ersten Kontaktelemente (310A) 24V Kontaktanschlüsse sind.

8. Abgreifvorrichtungssystem (1000) zur Übertragung elektrischer Energie von einer räumlich fixierten Leitungsschiene (1) auf eine entlang der Leitungsschiene (1) bewegbaren oder ebenso räumlich fixierten Abgreifeinrichtung (2),
**dadurch gekennzeichnet, dass**
das Abgreifvorrichtungssystem (1000) zumindest zwei Abgreifvorrichtungen (100) gemäß einem der vorhergehenden Ansprüche aufweist, die entlang der Leitungsschiene (1) an einer Verbindungsvorrichtung (7) hintereinander angeordnet sind.

9. Abgreifvorrichtungssystem (1000) nach Anspruch 8,
**dadurch gekennzeichnet, dass**
die Verbindungsvorrichtung (7) in Form einer Verbindungsplatte ausgebildet ist.

## Claims

1. Tapping apparatus (100) for transmitting electrical energy from a spatially fixed, busbar (1) to a tapping device (2) which can be moved along the busbar (1) or is also spatially fixed, comprising:
- at least one connection housing (10), the busbar (1) being mechanically connected to the tapping device (2) by means of the connection housing (10),
- a current tapping apparatus (3) which comprises sliding contact elements (31) for collecting electrical energy from the busbar (1), the current tapping apparatus (3) being mechanically rigidly connected to the connection housing (10),
- **characterized in that**
the connection housing (10) comprises at least one base support (10A), on which an upper control circuit boards (100A) and a lower control circuit boards (100A) are mounted, the base support (10A) being mounted between the two control circuit boards (100A), and thus the two control circuit boards (100A) are mounted one above the other, so stacked arranged, in a direction perpendicular to a direction of travel (200).

2. Tapping apparatus (100) according to claim 1,
**characterized in that**
the control circuit boards (100A) are each designed and intended to drive, to control and/or to regulate at least one electric motor.

3. Tapping apparatus (100) according to claim 1 or 2,
**characterized in that**
the control circuit boards (100A) have at least one voltage pick-up of +24 V and/or +48 V.

4. Tapping apparatus (100) according to at least one of the preceding claims,
**characterized in that**
the sliding contact elements (31) are formed by a first number of first contact elements (310A) for supplying power at least one first voltage of one of the control circuit boards (100A), and by a second number of contact elements (310A, 310B) for supplying power at least one second voltage of another control circuit board (100A), at least two contact element groups thus being formed, the individual contact elements (310A, 310B) in each group being arranged one after the other in a direction of travel (220) of the connection housing (10), and each group separately supplying a control circuit board (100A) uniquely assigned thereto with electrical power, wherein contact elements (310C) being formed as an earth connection (GND terminal) between the first contact elements (310A) and the second contact elements (310B) in a direction perpendicular to the direction of travel (200).

5. Tapping apparatus (100) according to claim 4,
**characterized in that**
the current tapping apparatus (3) comprises at least one further sliding contact element (32B), it being possible to supply at least one of the control circuit boards (100A) with electrical power by means of said further sliding contact element (32B).

6. Tapping apparatus (100) according to any of preceding claims 5,
**characterized in that**
the further sliding contact element (32B) is arranged between two of the sliding contact elements (31) of the first contact elements (310A) in the direction of travel (200).

7. Tapping apparatus (100) according to any of preceding claims 4 to 6,
**characterized in that**
the second contact elements (310B) are 48 V contact terminals, and the first contact elements (310A) are 24 V contact terminals.

8. Tapping apparatus system (1000) for transmitting electrical energy from a, spatially fixed, busbar (1) to a tapping device (2) which can be moved along the busbar (1) or is also spatially fixed,
**characterized in that**
the tapping apparatus system (1000) comprises at least two tapping apparatus (100), according to one of the preceding claims, which are arranged in series along the busbar (1) on a connection apparatus (7).

9. Tapping apparatus system (1000) according to preceding claim 8,
**characterized in that**
the connection apparatus (7) is in the form of a connection sheet (71).

## Revendications

1. Dispositif de captage (100) pour la transmission d'énergie électrique d'un rail (1) fixe dans l'espace à un dispositif de captage (2) mobile le long du rail (1) ou à un dispositif de captage (2) également fixe dans l'espace, comprenant:
- un boîtier de raccordement (10), par lequel le rail conducteur (1) peut être relié mécaniquement au rail conducteur par l'intermédiaire du boîtier de raccordement (10),
- un dispositif de captage de courant (3) comprenant des éléments de contact glissants (31) pour capter l'énergie électrique du rail conducteur (1), le dispositif de captage de courant (3) étant fixé mécaniquement au boîtier de connexion (10), et le boîtier de connexion (10) est relié à l'élément de connexion (10)
**caractérisé en ce que**
ledit boîtier de connexion (10) comprend au moins un support de base (10A) sur lequel une carte de commande supérieure (100A) et une carte de commande inférieure sont montées, ledit support de base (10A) étant monté entre lesdites deux cartes de commande (100A) et ainsi les deux cartes de commande (100A) sont disposées l'une sur l'autre, c'est-à-dire empilées, dans une direction perpendiculaire à une direction de déplacement (200).

2. Dispositif de captage (100) selon la revendication 1,
charactérisé en ce que
les cartes de commande (100A) sont chacune en outre, dans lequel les cartes de commande (100A) sont chacune disposées et prévues pour entraîner, commander et/ou réguler au moins un moteur.

3. Dispositif de captage (100) selon la revendication 1 ou 2,
**caractérisé en ce que**
les cartes de commande (100A) ont au moins une consommation de tension de +24V et/ou +48V.

4. Dispositif de captage (100) selon l'une quelconque des revendications précédentes,
**caractérisé en ce que**
les éléments de contact coulissants (31) sont formés par un premier nombre de premiers éléments de contact (310A) pour l'alimentation électrique avec au moins une première tension de l'une des cartes de commande (100A), et un deuxième nombre d'éléments de contact (310B) pour l'alimentation électrique avec au moins une deuxième tension d'une autre carte de commande (100A), formant ainsi au moins deux groupes d'éléments de contact, dans lequel les éléments de contact individuels (310A, 310B) de chaque groupe étant disposés l'un derrière l'autre dans une direction de déplacement (200) du boîtier de connexion (10), et chaque groupe alimentant séparément en énergie électrique une carte de commande (100A) qui lui est associée de manière univoque, des éléments de contact (310C) étant formés dans une direction perpendiculaire à la direction de déplacement (200) entre les premiers éléments de contact (310A) et les seconds éléments de contact (310B) en tant que connexion de masse (GND).

5. Dispositif de prélèvement (100) selon la revendication 4,
**caractérisé en ce que**
le dispositif de détection de courant (3) présente au moins un autre élément de contact coulissant (32A), au moyen duquel au moins un des tableaux de commande (100A) peut être alimenté en énergie électrique.

6. Dispositif de prélèvement (100) selon la revendication 5,
**caractérisé en ce que**
l'autre élément de contact glissant (32B) est disposé dans le mode de réalisation entre deux des éléments de contact glissant (31) des premiers éléments de contact (310A).

7. Dispositif de préhension (100) selon l'une quelconque des revendications 4 à 6 précédentes,
**caractérisé en ce que**
les seconds éléments de contact (310B) sont des bornes de contact 48V et les premiers éléments de contact (310A) sont des bornes de contact 24V. (310A) sont des bornes de contact 24V.

8. Système de dispositif de captage (1000) pour la transmission d'énergie électrique d'un rail conducteur fixe (1) à un dispositif de captage (2) mobile le long du rail conducteur (1) ou à un dispositif de captage (2) également fixe dans l'espace,
**caractérisé en ce que**
le système de dispositifs de captage (1 000) comprend au moins deux dispositifs de captage (100) selon l'une quelconque des revendications précédentes, qui sont disposés en série le long du rail linéaire (1) sur un dispositif de connexion (7).

9. Système de dispositif de ramassage (1000) selon la revendication précédente 7,
**caractérisé en ce que**
le dispositif de connexion (7) se présente sous la forme d'une plaque de connexion (71).
